# EUROPEAN PATENT SPECIFICATION

(11) **EP 1 550 133 B1**
(45) Date of publication and mention of the grant of the patent: **21.02.2007**
(21) Application number: 03760179.6
(22) Date of filing: 16.06.2003
(51) Int. Cl.: G11C 11/22, C23C 14/24, H01L 21/285

(54) **A METHOD FOR MAKING A FERROELECTRIC MEMORY CELL IN A FERROELECTRIC MEMORY DEVICE, AND A FERROELECTRIC MEMORY DEVICE**
VERFAHREN ZUR HERSTELLUNG EINER FERROELEKTRISCHEN SPEICHERZELLE IN EINEM FERROELEKTRISCHEN SPEICHERBAUSTEIN UND FERROELEKTRISCHER SPEICHERBAUSTEIN
PROCEDE POUR FABRIQUER UNE CELLULE MEMOIRE FERROELECTRIQUE DANS UN DISPOSITIF MEMOIRE FERROELECTRIQUE, ET DISPOSITIF MEMOIRE FERROELECTRIQUE

(30) Priority: 18.06.2002 NO 20022910
(43) Date of publication of application: 06.07.2005
(73) Proprietor: Thin Film Electronics ASA, 0124 Oslo (NO)
(72) Inventor: LJUNGCRANTZ, Henrik, S-587 21 Linköping (SE); EDVARDSSON, Niclas, S-59054 Sturefors (SE); CARLSSON, Johan, S-589 29 Linköping (SE); GUSTAFSSON, Göran, S-582 16 Linköping (SE)
(74) Representative: Altenburg, Udo
(86) International application number: PCT/NO2003/000198
(87) International publication number: WO 2003/107351

(56) References cited:
- WO-A1-00/01000
- US-B1- 6 359 289
- PATENT ABSTRACTS OF JAPAN vol. 0186, no. 31 30 November 1994 & JP 06 243 519 A (SHIGERU SAGAI) 02 September 1994

## Description

The present invention concerns a method for making a ferroelectric memory cell, comprising steps for
(a) providing a substrate consisting of a silicon layer, and optionally a silicon dioxide isolation layer;
(b) forming a first electrode comprising at least one metal layer and at least one metal oxide layer, and providing said first electrode adjacent to said substrate and in contact with said silicon layer or said optional silicon dioxide isolation layer;
(c) forming a first ferroelectric layer consisting of a polymer ferroelectric thin film, and providing said first ferroelectric layer adjacent to and in contact with said first electrode; and
(d) forming a second electrode comprising at least one metal layer and at least one metal oxide layer, and providing said second electrode adjacent to and in contact with said first ferroelectric layer.
   The present invention also concerns a ferroelectric memory device comprising ferroelectric memory cells capable of storing data in either one of at least two polarization states when no electric field is applied to the memory cells, wherein the ferroelectric memory device comprises at least one ferroelectric layer formed by a polymer ferroelectric thin film and at least a first set and a second set of respective parallel electrodes, wherein the electrodes of the first set are provided in substantially orthogonal relationship to the electrodes of said second set, said first set and second set of electrodes contacting ferroelectric memory cells at opposite surfaces of said at least one polymer ferroelectric layer, and wherein at least the first set and second set of electrodes are adapted to read, refresh or write ferroelectric memory cells by applying appropriate voltages thereto.
   Ferroelectrics are electrically polarizable materials that possess at least two equilibrium orientations of the spontaneous polarization vector in the absence of an external electrical field, and in which the spontaneous polarization vector may be switched between those orientations by an electric field. The memory effect exhibited by materials with such bistable states of remanent polarization can be used in memory applications. One of the polarization states is considered to be a logic "1" and the other state a logic "0". Typical passive matrix-addressing memory applications are implemented by letting two sets of parallel electrodes cross each other, usually in an orthogonal fashion, in order to create a matrix of cross-points that can be individually accessed electrically by selective excitation of the appropriate electrodes from the edge of the matrix. A layer of ferroelectric material is provided between the electrode sets in a capacitor-like structure such that memory cells are defined in the ferroelectric material between the electrode crossings. When applying potential differences between two electrodes, the ferroelectric material in the cell is subjected to an electric field which generates a polarization response generally tracing a hysteresis curve or a portion thereof. By manipulating the direction and the magnitude of the electric field, the memory cell can be left in a desired logic state. The passive addressing of this type of arrangement leads to simplicity of manufacture and allows a high density of cross-points or memory cells.
   Sputtering is a method commonly used for depositing different types of layers in ferroelectric memory devices. The bottom and upper electrode sets are often deposited by sputtering and sometimes the ferroelectric memory layer as well. Published International Patent Application No. WO 00/01000 (Hayashi & al.) discloses the use of a direct current magnetron reactive sputtering process for creating a smooth bottom electrode made of e.g. platinum. A gas mixture of a noble gas and either oxygen gas or nitrogen gas is used. This reduces the amount of surface irregularities such as sharp hillocks and leads to improved fatigue endurance, polarization and imprint characteristics. While there are relatively few problems with performing such methods on devices with perovskite ferroelectric cells, e.g. lead zirconium titanate (PZT) which is a very popular alternative, another type of problem needs to be addressed, however, for ferroelectric memory devices with polymer as a memory material. The sputtering of the upper electrode may damage the polymer ferroelectric cells, and hence another method for providing the upper electrode is required.
   U.S. Patent No. 6,359,289 (Parkin) discloses the making of a magnetic tunnel junction device, wherein an insulating tunnel barrier is preferably thermally evaporated onto a fixed ferromagnetic layer. Similar to the way ferroelectric memory devices function, the two ferromagnetic layers on either side of the insulating tunnel barrier can assume different magnetization directions, i.e. a relative orientation of the magnetic moments, and consequently be operated as a non-volatile random access memory. The insulating tunnel barrier is primarily made of gallium and/or indium oxide or nitride. Additionally, an oxide or nitride of aluminum can form part of the barrier material in the form of an extra layer. The preferred method of preparing gallium oxide is by depositing gallium from an effusion source in the presence of oxygen gas or in the presence of more reactive oxygen provided by an atomic oxygen source or other source. However, the problem addressed herein is that of high resistance-area values, i.e. large tunnel barrier energy height. Therefore, the solution for thermally evaporating gallium and/or indium oxide or nitride does not address the problem present when electrode material shall be deposited or formed on an underlying polymer layer.
   Further there is from EP patent application No. 567 870 A1 (Puffmann, assigned to Ramtron Int. Corp.) known a ferroelectric capacitor for use in a ferroelectric memory device. Generally this publication discloses a composite bottom electrode comprising an additional layer of palladium and a contact layer of e.g. platinum metal, or an alloy of platinum and other metals. The ferroelectric memory material is here an inorganic material, e.g. lead zirconium titanate (PZT) which is well-known in the art. The top electrode on the opposite side can be similarly composite and consist of platinum or an alloy of platinum and other metals. As the ferroelectric material in any case is an inorganic material such as PZT, thermal incompatibility between this material and the process for depositing the top electrode does not constitute a problem.
   Thus it is a primary object of the present invention to provide a method for making an electrode layer for memory cells in a ferroelectric memory device, and particularly it is an object of the present invention to provide a method for making an upper electrode layer for memory cells in a ferroelectric memory device. Even more particularly it is an object of the present invention to provide a method for depositing the electrode metal for an upper electrode onto a ferroelectric memory layer in the form of a ferroelectric polymer.
   A further object of the present invention is to provide a ferroelectric memory device made with the method according to the invention.
   The above-mentioned objects as well as further features and advantages are realized according to the invention with a method which is characterized by step (d) further comprising forming one metal oxide layer by placing said substrate, said first electrode and said first ferroelectric layer in a vacuum chamber, providing a high-purity evaporation source in an effusion cell, said effusion cell being provided in said vacuum chamber, evaporating thermally said high-purity evaporation source from said effusion cell onto the surface of said first ferroelectric layer while supplying a working gas at a first gas pressure; and forming one of said at least one metal layer by evaporating thermally said high-purity evaporation source from said effusion cell onto the surface of said at least one metal oxide layer while maintaining a second gas pressure.
   Preferably the high-purity evaporation source is high-purity titanium. Further preferably at least one metal layer of the second electrode is a layer of titanium and the at least one metal oxide layer of the second electrode a layer of titanium oxide, titanium dioxide and a combination of titanium oxide and titanium dioxide.
   Preferably the working gas is oxygen gas or a gas mixture of at least oxygen gas or nitrogen gas. In the latter case the oxygen gas constitutes less than 50% by volume of the working gas and the nitrogen gas more than 50% by volume of the working gas and preferably the oxygen gas then constitutes 15 to 25% of the working gas by volume.
   Advantageously the gas pressure in the vacuum chamber is between 133,310⁻³ and 133,3 10⁻⁶ Pa (10⁻³ and 10⁻⁶ Torr).
   Advantageously the effusion cell comprises a crucible made of carbon in its graphite form, and the crucible can then preferably be heated to between 1600 and 1900°C during the thermal evaporation of the high-purity of evaporation source.
   A preferable embodiment according to the invention further comprises steps for
(e) forming a second ferroelectric layer consisting of a polymer ferroelectric thin film, said second ferroelectric layer being provided adjacent to and in contact with said second electrode;
(f) forming a third electrode comprising at least one metal layer and at least one metal oxide layer by thermal evaporation, said third electrode being provided adjacent to and in contact with said second ferroelectric layer;
(g) forming a first dielectric interlayer consisting of a dielectric material, said first dielectric interlayer being provided adjacent to and in contact with said third electrode; and
(h) repeating steps (b) through (g) at least once such that a stacked structure of at least four ferroelectric memory cells is made whereby the substrate in step (b) is replaced by the electrode in step (d) and the electrodes, ferroelectric layers and dielectric layers are correspondingly numbered.

In this connection it is preferred that step (h) is repeated two times, and further comprises a step for (i) forming a thirteenth electrode comprising at least one metal layer and at least one metal oxide layer, the thirteenth electrode being electrically connected with at least two of the other electrodes.

The invention also concerns a ferroelectric memory device characterized in that said first set of electrodes comprises at least one metal layer and at least one metal oxide layer, said first set of electrodes being provided adjacent to a substrate and in contact with a silicon layer, or optionally a silicon dioxide isolation layer, that said second set of electrodes comprises at least one metal layer and at least one metal oxide layer, said second set of electrodes being provided adjacent to and in contact with a ferroelectric layer, and that said second set of electrodes is formed in a vacuum chamber by thermally evaporating a high-purity evaporation source from an effusion cell onto the surface of said ferroelectric layer while providing a working gas at respectively a first and a second gas pressure.

In a preferred embodiment the ferroelectric memory device comprises three or more set of electrodes and at least two ferroelectric layers each set of electrodes being provided adjacent to and in contact with at least one ferroelectric layer and each ferroelectric layer being provided between and in contact with two sets of electrodes.

The present invention shall now be explained in greater detail by means of a discussion of exemplary embodiments thereof and in conjunction with the appended drawing figures, of which
fig. 1 shows a schematic hysteresis curve of a ferroelectric memory material;
fig. 2a schematically a principle for a passive matrix-addressing device with orthogonally crossing first and second electrodes provided in parallel in respective electrode sets;
fig. 2b the device in fig. 2a with memory cells comprising ferroelectric material provided between the crossing electrodes;
fig. 3 a block diagram of a memory device according to a preferred embodiment of the invention;
fig. 4 schematically a partial cross section of an effusion cell as used with an embodiment of the method according to the invention;
fig. 5 schematically a cross section of a ferroelectric memory cell as used with an embodiment of the memory device according to the invention; and
fig. 6 schematically a cross section of four stacked ferroelectric memory cells in another embodiment according to the invention.

Before the present invention is explained with reference to preferred embodiments a brief review of its general background shall be given with particular reference to the structure of matrix-addressable ferroelectric memories and how they generally are addressed for readout.

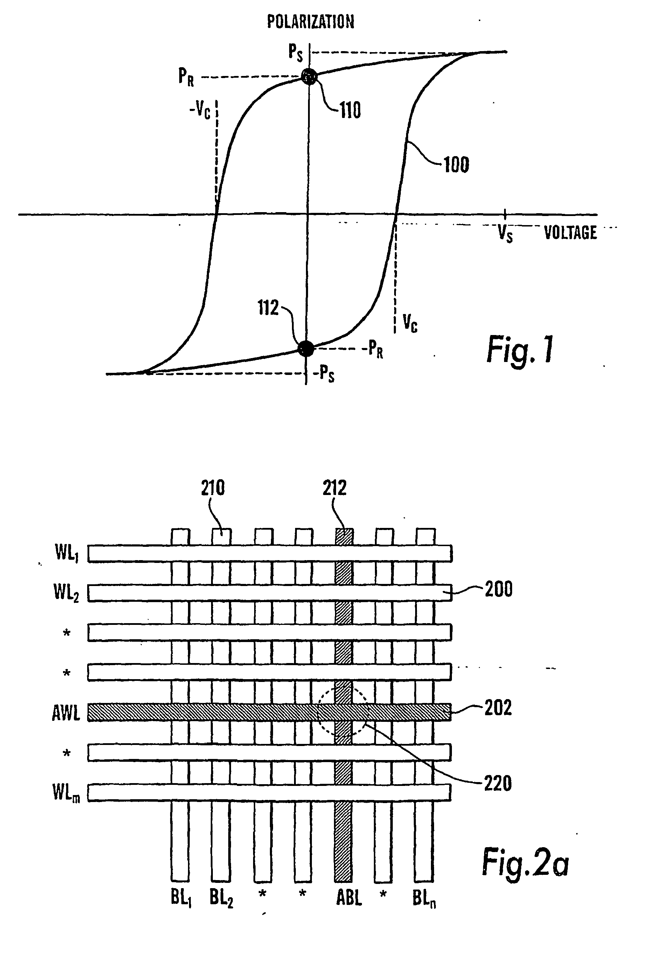

Fig. 1 shows a hysteresis curve 100 for a ferroelectric material. Here the polarization P is rendered as a function of the voltage V. The positive saturation polarization is denoted by P_{S} and the negative saturation polarization by -P_{S}. P_{R} and -P_{R} denote respectively the positive and negative remanent polarization, i.e. the two permanent polarization states which can be present in a ferroelectric memory cell and which can be used for representing logic "1" or "0" as is the case. V_{S} and -V_{S} denote respectively the positive and negative coercive voltage. It is to be understood that when a polarization is given as a function of voltage, is this based on practical considerations. Generally voltage could be replaced by the electric field strength E and equally generally shall then E_{C} and -E_{C} respectively denote the positive and the negative coercive field strength for the ferroelectric material. The voltage can then be calculated by multiplying the field strength with the thickness of the ferroelectric layer for a specific memory cell. The saturation polarizations P_{S} and -P_{S} will be attained each time a memory cell is subjected to respectively nominal switching voltages V_{S} and -V_{S} which exceed a coercive voltage V_{C} respectively -V_{C}. As soon as the applied electric field is removed, the ferroelectric material will relax and return to respectively one of the two remanent polarization states P_{R} and -P_{R}, herein also rendered as respectively the points 110 and 112 on the hysteresis curve. A change of the polarization direction, e.g. from the remanent positive polarization at point 110, takes place by applying a negative electric field -E_{S} or a negative voltage -V_{S} which then respectively can be denoted as the switching field or the switching voltage, and the ferroelectric material will then be driven to the negative saturation polarization -P_{S} and afterwards relax to the opposite polarization state -P_{R}. Correspondingly a positive switching field E_{S} or switching voltage V_{S} might change the negative polarization state -P_{R} to P_{R}. The use of switching protocols of this kind which also is known as pulse protocols, determines the electric field by applying voltages to the electrodes in the memory matrix during the write and read operations.

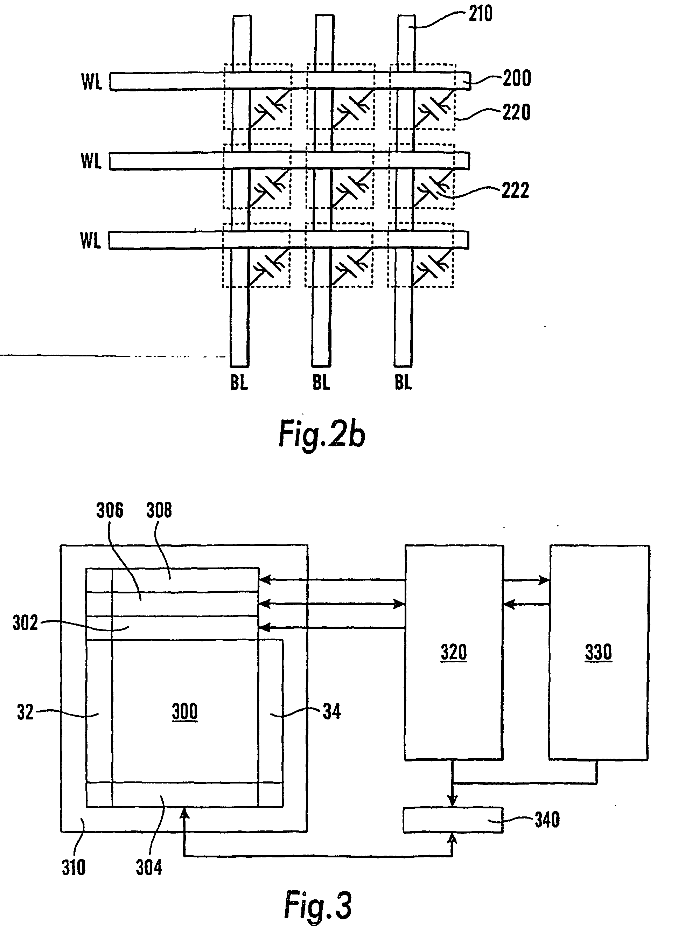

Fig. 2 shows a matrix with orthogonally crossing electrodes. According to standard terminology the horizontal electrodes of the row electrodes shall hereinafter be denoted as word lines 200, abbreviated WL, and vertically electrodes or column electrodes as bit lines 210, abbreviated BL. As shown in fig. 2a the matrix can be a matrix with m word lines WL and n bit lines BL such that it appears as an m·n matrix with of course then a total of m·n memory cells defined in the cross points between the word lines WL and bit lines BL. In fig. 2b there is shown a section of the matrix in fig. 2a and wherein memory cells 220 is indicated between the crossing word lines WL and bit lines BL. The ferroelectric material in the memory cell 220 then forms a dielectric capacitor-like structure with respectively a word line WL and bit line BL, e.g. 200 and 210, as electrodes. During the driving and detecting operation word lines 202 and bit lines 212 are activated to respectively active word lines AWL and active bit lines ABL. It can then be applied a voltage which is sufficiently high to switch the polarization direction of a given memory cell as shown in fig. 2b either to define a specific polarization direction in the cell, which conforms to a write operation, or for detecting or monitoring the set polarization direction, something which constitutes a read operation. The ferroelectric material or the ferroelectric layer located between the electrodes functions as mentioned above as a ferroelectric capacitor 222. The memory cell 220 is thus selected by setting the potentials of the associated word line 202 and bit line 212, i.e. the active word line AWL and the active bit line ABL such that the difference conforms to the nominal switching voltage V_{S}. Simultaneously it must be seen to that the remaining word lines and bit lines, for instance represented by 200 and 210 in fig. 2a and which crosses at memory cells 220, which are not to be addressed, shall be controlled in regard of electric potential, such that so-called disturb voltages at non-addressed memory cells 220 are kept at a minimum.

As the method according to the present invention concerns ferroelectric memory devices and particularly wherein the ferroelectric memory material is a polymer, an example of a ferroelectric memory device of this kind shall be given in order to ease the understanding of its function.

Fig. 3 shows in a simplified block diagram form the structure and the functional elements of a matrix-addressable ferroelectric memory device which can be adapted for the purposes of the present invention and wherein e.g. the method according to the invention can be applied. The memory macro 310 comprising of a memory array or matrix 300, row and column decoders 32;302, sense amplifiers 306, data latches 308 and redundant word and bit lines 304;34. The row and column decoders 32;302 decode the addresses of memory cells, while sensing is performed by the sense amplifiers 306. Data latches 308 hold the data read until part or all of the data are transferred to the memory control logic or logic module 320. The data read from the memory macro 310 will have a certain bit error rate (BER) which can be reduced by replacing defective word and bit lines in the memory array 300 with redundant word and bit lines 304;34. In order to perform error detection the memory macro 310 may have data fields containing error correction code (ECC) information. The memory control logic 320 provides a digital interface for the memory macro 310 and controls the write and read operations on the memory array 300. Memory initialisation and logic for replacing defective bit and word lines with redundant word and bit lines 304;34 will be found in the memory control-logic 320 as well. The device controller 330 for the memory device connects the memory control logic 320 to external bus standards. A voltage generator or charge pump mechanism 340 generates some of the voltages needed for writing and reading the memory cells. A separate clock input to the charge pump 340 from the device controller 330 via an oscillator (not shown), will be used by the charge pump 340 for generating voltages or perform charge pumping independently of the bit rate of the application using the memory macro 310.

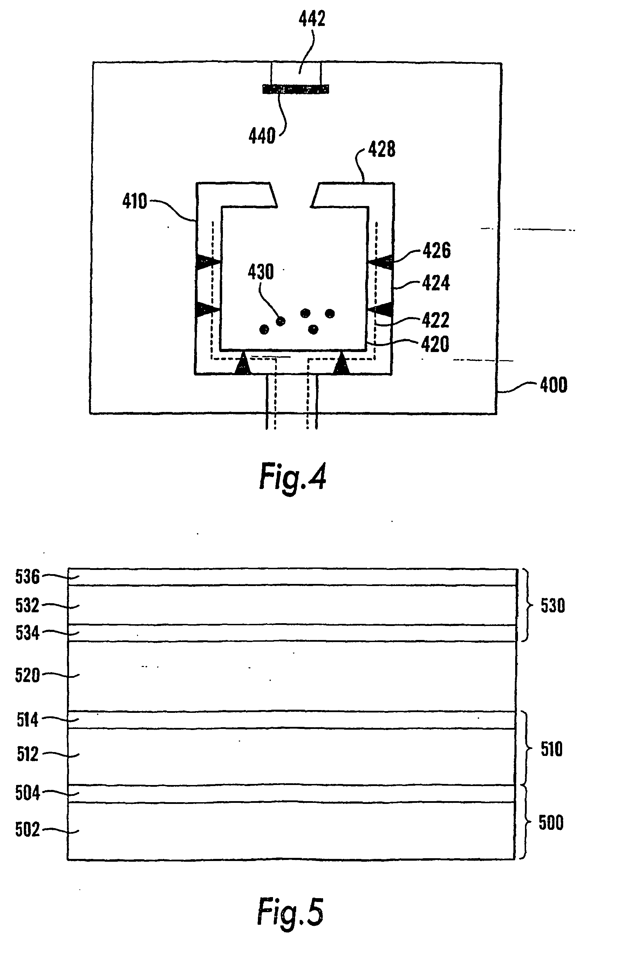

As the method according to the present invention applies to the making of an electrode layer by thermal evaporation of an electrode material from an effusion cell, an example of how such an effusion cell is realized and works shall now be given. In that connection an effusion cell shall be discussed in a generalized fashion, with reference to figure 4.

Fig. 4 shows an effusion cell 410 which comprises, among other, a crucible 420, heating elements 422, a housing 424, supports 426 and a cover 428. During a work operation the crucible is filled with an evaporation source 430 of high-purity which is then evaporated onto the substrate 440. The crucible 420 may be of any desired shape and may be composed of any suitable refractory material such as graphite, tantalum, molybdenum or pyrolytic boron nitride. A set of supports 426 secures the crucible 420 inside the housing 424. In order to evaporate the evaporation source 430 heating elements 422 are used. The number and location of the heating elements 422 may vary between various arrangements. Sometimes the heating elements 422 are placed in proximity to the opening of the crucible 420 such that condensation of evaporation source 430 in this area is avoided. The housing 424 and the cover 428 shield the surroundings from heat radiation. A thermoelement can be included within the housing 424 to keep track of the temperature and its development. The effusion cell 410 as well as the substrate 440 are here located within a vacuum chamber 400 which can be filled with a working gas, but also can be used for providing a vacuum environment. The substrate 440 is mounted on a holder 442 which can be rotatable or not depending on the needs of the particular situation. This simplistic description may be complemented, if so desired, by the more detailed descriptions which are found in e.g. U.S. Patent No. 6,011,904 (Mattord) or U.S. Patent No. 6,162,300 (Bichrt), to which reference is made without any of them having a limiting effect on the present invention in any way.

Specific and preferred embodiments of the method according to the invention for making an electrode layer in a ferroelectric memory device embodied as discussed in the foregoing, shall now be described in relation to the more general problem connected with defects and deficiencies in the properties arising when an electrode layer is sputtered on the top of a memory layer made of a polymer material. Particularly these defects and deficiencies in the properties shall appear in the form of a memory material with poor polarization properties and poor fatigue endurance, i.e. a tendency of loosing polarization and that the remanent polarization value decreases (for instance with an increasing number of switching cycles, reversal of the polarization directions and generally due to disturb voltages and stray capacitances in the memory cell array).

According to the invention it is generally proposed to solve the problem with damages on a ferroelectric memory layer, above all a memory layer of ferroelectric polymer, by thermally evaporating the electrode metal from an effusion cell onto the ferroelectric memory layer. This presupposes that the ferroelectric memory device can be made by different depositing methods. Spin coating is the best-suited and usual method for applying a ferroelectric memory layer of polymer material. The bottom electrode set can still be sputtered, as the silicon substrate can be regarded as being thermally compatible with the process and hence shall not be damaged. However, the upper electrode set must be evaporated to avoid damaging the memory material, e.g. a ferroelectric polymer material which has a relatively low melting point, typically in the order of about 200°C.

Fig. 5 shows schematically in cross section a ferroelectric memory cell. It is formed on a substrate 500 and comprises a first or bottom electrode 510, a first ferroelectric layer 520, and a second or upper electrode 530. In a first preferred embodiment the substrate 500 consists of a silicon layer 502 and on this a silicon dioxide isolation layer 504 which are made in an as per se known manner. Sputtering is used to deposit the first or bottom electrode 510. A number of metals is suitable as electrode material, but titanium is preferably used. In order to deposit the polymer ferroelectric layer 520 by spin coating as usually employed, the device, i.e. the substrate and the electrodes, must be transferred from one manufacturing equipment to another. During this transfer oxidization of the electrodes takes place and the electrode 510 shall thereby consist of a first metal layer 512 and a first metal oxide layer 514 thereon. This is, however, a not unwanted effect, since the first metal oxide layer 514 may function as a barrier layer, preventing diffusion, or as an adhesion layer preventing separation that might lead to a reduced fatigue endurance or contact faults. The first ferroelectric layer 520 is then formed by spin-coating a polymer on top of the bottom electrode 510. Following this, a method according to the present invention is used to deposit the second or upper electrode 530 by means of thermal evaporation. Again a number of metals is suitable, but titanium is preferably used. In order to form a second metal oxide layer 534 in the second electrode layer 530 and similar to the first metal oxide layer 514 in the first electrode layer 510 such that the second metal oxide layer 534 contacts the first ferroelectric layer 520 and functions as adhesion layer or offers other functionalities, the vacuum chamber 400 is filled with a working gas during the operation. This working gas includes at least either oxygen or nitrogen. In the case of oxygen used as a working gas there will be formed, on top of the first ferroelectric layer 520, a layer of titanium oxide, titanium dioxide or a combination of titanium oxide and titanium dioxide. Once the second metal oxide layer 534 has reached a sufficient thickness the gas pressure is reduced and the thermal evaporation process continues resulting in a pure metal layer 532 being formed on the oxide layer 534. Again, the device is transferred to another manufacturing equipment and a second metal oxide layer 536 is formed on the top of the metal layer 532.

The working gas is kept at a pressure between 133,3.10⁻³ and 133,3.10⁻⁶ Pa when forming the second metal oxide layer 534. The gas pressure during the remainder of the thermal evaporation process is sufficiently low to avoid the formation of oxides, but high enough to allow for a fast deposition rate in the process step for forming the second metal layer 532. There is a trade-off between the required purity of the second metal layer 532 and the time required to evacuate the vacuum chamber 400 or reduce the pressure therein to achieve the desired low gas pressure. As mentioned, the working gas may include either oxygen or nitrogen gas. One option is to use only oxygen gas. Another option is to use a mixture of oxygen and nitrogen gas. In the case of a mixture, the oxygen content is kept below 50% by volume and the nitrogen content consequently above 50% by volume. Preferably the oxygen content of the mixture is between 15% to 25% by volume. In certain embodiments the working gas may have further gaseous components.

For thermal evaporation a crucible 420 preferably made from carbon in its graphite form is used. It is filled with an evaporation source 430 which can be selected among a number of suitable metals, but preferably titanium of high purity is used. During the evaporation operation the crucible 420 will be heated to between 1600 and 1900 degrees centigrade.

The method according to the first preferred embodiment can be implemented with different variants. It is possible to use a substrate 500 with a silicon layer 502, but without the silicon dioxide layer 504. Similarly, the first electrode 510 can consist of more than one first metal layer 512 or more than one first metal oxide layer 514 if necessary, and these layers 512, 514 then can be provided in any suitable order. This can be achieved by successive deposition processes with different metals or by changing the working gas of e.g. an effusion process. Corresponding processual considerations may also be applied to the second electrode 530.

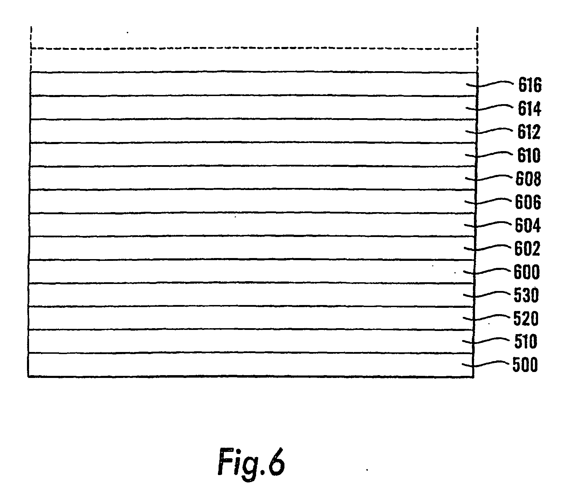

A second preferred embodiment is based on the same process steps as in the first preferred embodiment and comprises in addition some further steps. After depositing the first electrode 510, the first ferroelectric layer 520 and the second electrode 530 in succession on the substrate 500, the deposition process can continue, as shown in figure 6, with a second ferroelectric layer 600, a third electrode 602 and a first dielectric interlayer 604. A ferroelectric memory device with stacked memory cells can be built in this manner with as many memory cells as desired or as practical to realize. The first electrode 510 and the second electrode 530 are arranged such that potential differences can be applied between them and hence influence the polarization response of the first ferroelectric layer or memory material 520. Likewise the second electrode 530 and the third electrode 602 are provided such that potential differences applied between them can be used for influencing the polarization response of the second ferroelectric layer 600. Insulation before depositing further sets of electrodes and ferroelectric layers is provided by the dielectric interlayer 604. Now further ferroelectric memory cells in the stack can be formed, e.g. by continuing with the fourth electrode 606, a third ferroelectric layer 608, a fifth electrode 610, a fourth ferroelectric layer 612, a sixth electrode 614 and another dielectric interlayer 616. The fourth electrode 606 and the fifth electrode 610 are arranged in such a manner that potential differences may be applied therebetween and effect a polarization response of the third ferroelectric layer 608, while correspondingly the fifth electrode 610 and the sixth electrode 614 being formed such that potential differences can be applied therebetween and the polarization response of the fourth ferroelectric layer 612 influenced. Again, a required insulation is provided by the second dielectric interlayer 616 in case further memory cells are deposited and formed in the stack.

Particularly and in a third preferred embodiment it is regarded as practical that the steps of the method according to the present invention are repeated until the ferroelectric memory device comprises 12 electrodes, 8 ferroelectric layers and 4 insulation layers in the form of dielectric interlayers. Then a thirteenth electrode can be deposited in order to provide electrical contact between different locations in the ferroelectric memory device.

By employing the method according to the present invention it will be possible to manufacture a memory device with a high integration density in a volumetric or three-dimensional architecture. In commonly known embodiments there are for each ferroelectric memory layer used two sets of electrodes, viz. bottom and top electrodes, and in addition insulating dielectric interlayers. For a memory device with 8 ferroelectric layers of memory layers this implies 16 electrode layers and 8 dielectric layers or insulation layers, a total of 32 layers. By using an embodiment wherein the top electrode of the first memory layer forms the bottom of the second memory layer etc., 8 ferroelectric layers shall only require 9 electrode layers and possibly an insulating layer on the top, a total of eighteen layers. Thus a device with a total of 18 layers is obtained, but with the disadvantage that addressing of memory cells cannot take place to all ferroelectric layers simultaneously i.e. in parallel, but at most to every second, and further with the additional disadvantage that the possibility of sneak currents and undesired capacitive couplings increases. The memory device according to the present invention provides a compromise and shall for 8 memory layers comprise a total of 24 layers, but with improved addressing possibilities as the use of 4 isolation layers or interlayers offers a better protection against undesired couplings, e.g. stray capacitances, between the memory layers in the volumetric structure. Realized with the method according to the present invention there is further achieved that the top electrodes of the ferroelectric layer or a memory layer can be deposited without damaging the ferroelectric memory material in the deposition process, something which is of essential importance when it is formed of a low melting point material such as a ferroelectric polymer.

## Claims

1. A method for making a ferroelectric memory cell, comprising steps for
(a) providing a substrate consisting of a silicon layer, and optionally a silicon dioxide isolation layer;
(b) forming a first electrode comprising at least one metal layer and at least one metal oxide layer, and providing said first electrode adjacent to said substrate and in contact with said silicon layer or said optional silicon dioxide isolation layer;
(c) forming a first ferroelectric layer consisting of a polymer ferroelectric thin film, and providing said first ferroelectric layer adjacent to and in contact with said first electrode; and
(d) forming a second electrode comprising at least one metal layer and at least one metal oxide layer, and providing said second electrode adjacent to and in contact with said first ferroelectric layer, the method being **characterized by** step (d) further comprising
forming one of said at least one metal oxide layer by placing said substrate, said first electrode and said first ferroelectric layer in a vacuum chamber, providing a high-purity evaporation source in an effusion cell, said effusion cell being provided in said vacuum chamber, evaporating thermally said high-purity evaporation source from said effusion cell onto the surface of said first ferroelectric layer while supplying a working gas at a first gas pressure; and forming one of said at least one metal layer by evaporating thermally said high-purity evaporation source from said effusion cell onto the surface of said at least one metal oxide layer while maintaining a second gas pressure.

2. A method according to claim 1, **characterized by** said high-purity evaporation source being high-purity titanium.

3. A method according to claim 2, **characterized by** said at least one metal layer of said second electrode being a layer of titanium and said at least one metal oxide layer of said second electrode being a layer of titanium oxide, titanium dioxide or a combination of titanium oxide and titanium dioxide.

4. A method according to claim 3, **characterized by** said working gas being oxygen gas.

5. A method according to claim 1, **characterized by** said working gas being a gas mixture of at least oxygen gas and nitrogen gas.

6. A method according to claim 5, **characterized by** the oxygen gas constituting less than 50% of said working gas by volume and the nitrogen gas constituting more than 50% of said working gas by volume.

7. A method according to claim 6, **characterized by** the oxygen gas constituting 15 to 25% of said working gas by volume.

8. A method according to claim 1, **characterized by** said first gas pressure in said vacuum chamber being between 133,3·10⁻³ and 133,3·10⁻⁶ Pa.

9. A method according to claim 2, **characterized by** said effusion cell comprising a crucible made from carbon in its graphite form.

10. A method according to claim 9, **characterized by** said crucible being heated to between 1600 and 1900 degrees centigrade during the thermal evaporation of said high-purity evaporation source.

11. A method according to claim 1, **characterized by** further comprising steps for
(e) forming a second ferroelectric layer consisting of a polymer ferroelectric thin film, said second ferroelectric layer being provided adjacent to and in contact with said second electrode;
(f) forming a third electrode comprising at least one metal layer and at least one metal oxide layer by thermal evaporation, said third electrode being provided adjacent to and in contact with said second ferroelectric layer;
(g) forming a first dielectric interlayer consisting of a dielectric material, said first dielectric interlayer being provided adjacent to and in contact with said third electrode; and
(h) repeating steps (b) through (g) at least once such that a stacked structure of at least four ferroelectric memory cells is made whereby the substrate in step (b) is replaced by the electrode in step (d) and the electrodes, ferroelectric layers and dielectric layers are correspondingly numbered.

12. A method according to claim 11, **characterized by** step (h) being repeated two times, and further comprising a step for
(i) forming a thirteenth electrode comprising at least one metal layer and at least one metal oxide layer, said thirteenth electrode being electrically connected to at least two of the other electrodes.

13. A ferroelectric memory device comprising ferroelectric memory cells capable of storing data in either one of at least two polarization states when no electric field is applied to the memory cells, wherein the ferroelectric memory device comprises at least one ferroelectric layer (520) formed by a polymer ferroelectric thin film and at least a first set and a second set of respective parallel electrodes (510;530), wherein the electrodes (510) of the first set are provided in substantially orthogonal relationship to the electrodes (530) of said second set, said first set and second set of electrodes (510;530) contacting ferroelectric memory cells at opposite surfaces of said at least one polymer ferroelectric layer (520), and wherein at least the first set and second set of electrodes (510;530) are adapted to read, refresh or write ferroelectric memory cells by applying appropriate voltages thereto,
**characterized in that**
said first set of electrodes (510) comprises at least one metal layer (512) and at least one metal oxide layer (514), said first set of electrodes (510) being provided adjacent to a substrate (500) and in contact with a silicon layer (502), or optionally, a silicon dioxide isolation layer (504),
that said second set of electrodes (530) comprises at least one metal layer (532) and at least one metal oxide layer (534), said second set of electrodes (530) being provided adjacent to and in contact with a ferroelectric layer (520), and
that said second set of electrodes (530) is formed in a vacuum chamber (400) by thermally evaporating a high-purity evaporation source (430) from an effusion cell (410) onto the surface of said ferroelectric layer (520) while providing a working gas at respectively a first and a second gas pressure.

14. A ferroelectric memory device according to claim 13, **characterized in** comprising three or more sets of electrodes (510,530,602,...), and at least two ferroelectric layers (520,600,...), each set of electrodes (510,530,602,...) being provided adjacent to and in contact with at least one ferroelectric layer (520,600,...) and each ferroelectric layer (520,600,...) being provided between and in contact with two sets of electrodes (510,530;530,602;...).

## Patentansprüche

1. Verfahren zum Herstellen einer ferroelektrischen Speicherzelle mit folgenden Schritten
(a) Vorsehen eines Substrats, welches aus einer Siliziumschicht und fakultativ aus einer Siliziumdioxidisolationsschicht besteht;
(b) Bilden einer ersten Elektrode, welche mindestens eine Metallschicht und mindestens eine Metalldioxidschicht aufweist, und Vorsehen der ersten Elektrode benachbart zu dem Substrat und in Berührung mit der Siliziumschicht oder der fakultativen Siliziumdioxidisolationsschicht;
(c) Bilden einer ersten ferroelektrischen Schicht, welche aus einem polymeren ferroelektrischen dünnen Film besteht, und Vorsehen der ersten ferroelektrischen Schicht benachbart zu und in Berührung mit der ersten Elektrode; und
(d) Bilden einer zweiten Elektrode, welche mindestens eine Metallschicht und mindestens eine Metalloxidschicht aufweist, und Vorsehen der zweiten Elektrode benachbart zu und in Berührung mit der ersten ferroelektrischen Schicht,
**dadurch gekennzeichnet, dass** der Schritt (d) weiter aufweist
Bilden einer der mindestens einen Metalloxidschicht durch Anordnen des Substrats, der ersten Elektrode und der ersten ferroelektrischen Schicht in einer Vakuumkammer,
Vorsehen einer Hochreinheits-Verdampfungsquelle in einer Effusionszelle, wobei die Effusionszelle in der Vakuumkammer vorgesehen ist, thermisches Verdampfen der Hochreinheits-Verdampfungsquelle von der Effusionsquelle auf die Oberfläche der ersten ferroelektrischen Schicht, während ein Arbeitsgas bei einem ersten Gasdruck zugeführt wird; und Bilden einer der mindestens einen Metallschicht durch thermisches Verdampfen der Hochreinheits-Verdampfungsquelle von der Effusionszelle auf die Oberfläche der mindestens einen Metalloxidschicht, während ein zweiter Gasdruck aufrechterhalten wird.

2. Verfahren nach Anspruch 1, **dadurch gekennzeichnet, dass** die Hochreinheits-Verdampfungsquelle hochreines Titan ist.

3. Verfahren nach Anspruch 2, **dadurch gekennzeichnet, dass** die mindestens eine Metallschicht der zweiten Elektrode eine Schicht aus Titan und die mindestens eine Metalloxidschicht der zweiten Elektrode eine Schicht aus Titanoxid, Titandioxid oder einer Kombination von Titanoxid und Titandioxid ist.

4. Verfahren nach Anspruch 3, **dadurch gekennzeichnet, dass** das Arbeitsgas ein Sauerstoffgas ist.

5. Verfahren nach Anspruch 1, **dadurch gekennzeichnet, dass** das Arbeitsgas eine Gasmischung mindestens eines Sauerstoffgases und eines Stickstoffgases ist.

6. Verfahren nach Anspruch 5, **dadurch gekennzeichnet, dass** das Sauerstoffgas weniger als 50 Vol.-% des Arbeitsgases und das Stickstoffgas mehr als 50 Vol.-% des Arbeitsgases bildet.

7. Verfahren nach Anspruch 6, **dadurch gekennzeichnet, dass** das Sauerstoff 15 bis 25 Vol.-% des Arbeitsgases bildet.

8. Verfahren nach Anspruch 1, **dadurch gekennzeichnet, dass** der erste Gasdruck in der Vakuumkammer zwischen 133,3 10⁻³ und 133,3 10⁻⁶ Pa ist.

9. Verfahren nach Anspruch 2, **dadurch gekennzeichnet, dass** die Effusionszelle einen Schmelztiegel, hergestellt aus Kohlenstoff in Graphitform, aufweist.

10. Verfahren nach Anspruch 9, **dadurch gekennzeichnet, dass** der Schmelztiegel auf 1600 bis 1900 Grad Celsius während der thermischen Verdampfung der Hochreinheits-Verdampfungsquelle erhitzt wird.

11. Verfahren nach Anspruch 1, **gekennzeichnet durch** folgende weitere Schritte:
(e) Bilden einer zweiten ferroelektrischen Schicht, welche aus einem polymeren ferroelektrischen dünnen Film besteht, wobei die zweite ferroelektrische Schicht benachbart zu und in Berührung mit der zweiten Elektrode vorgesehen ist;
(f) Bilden einer dritten Elektrode, welche mindestens eine Metallschicht und mindestens Metalloxidschicht aufweist, **durch** thermische Verdampfung, wobei die dritte Elektrode benachbart zu und in Berührung mit der zweiten ferroelektrischen Schicht vorgesehen ist;
(g) Bilden einer ersten dielektrischen Zwischenschicht, welche aus einem dielektrischen Material besteht, wobei die erste dielektrische Zwischenschicht benachbart zu und in Berührung mit der dritten Elektrode vorgesehen ist; und
(h) Wiederholen der Schritte (b) bis (g) mindestens ein Mal derart, dass ein gestapelter Aufbau von mindestens vier ferroelektrischen Speicherzellen hergestellt wird, wobei das Substrat in Schritt (b) **durch** die Elektrode in Schritt (d) ersetzt wird und die Elektroden, ferroelektrischen Schichten und dielektrischen Schichten entsprechend nummeriert werden.

12. Verfahren nach Anspruch 11, **dadurch gekennzeichnet, dass** der Schritt (h) zwei Mal wiederholt wird, und folgender weiterer Schritt vorgesehen ist:
(i) Bilden einer dreizehnten Elektrode, welche mindestens eine Metallschicht und mindestens eine Metalloxidschicht aufweist, wobei die dreizehnte Elektrode elektrisch mit mindestens zwei der anderen Elektroden verbunden ist.

13. Ferroelektrische Speichervorrichtung, welche ferroelektrische Speicherzellen aufweist, welche Daten in einem von mindestens zwei Polarisationszuständen speichern können, wenn an den Speicherzellen kein elektrisches Feld anliegt, wobei die ferroelektrische Speichervorrichtung mindestens eine ferroelektrische Schicht (520), gebildet durch einen polymeren ferroelektrischen dünnen Film, und mindestens einen ersten Satz und einen zweiten Satz von entsprechenden parallelen Elektroden (510; 530) aufweist, wobei die Elektroden (510) des ersten Satzes in im Wesentlichen orthogonaler Beziehung zu den Elektroden (530) des zweiten Satzes vorgesehen sind, der erste Satz und der zweite Satz der Elektroden (510; 530) ferroelektrische Speicherzellen an gegenüberliegenden Oberflächen der mindestens einen polymeren ferroelektrischen Schicht (520) berühren, und wobei mindestens der erste Satz und der zweite Satz von Elektroden (510; 530) geeignet sind, ferroelektrische Speicherzellen durch Anlegen geeigneter Spannungen zu lesen, wieder aufzufrischen oder zu schreiben,
**dadurch gekennzeichnet, dass**
der erste Satz von Elektroden (510) mindestens eine Metallschicht (512) und mindestens eine Metalloxidschicht (514) aufweist, wobei der erste Satz von Elektroden (510) benachbart zu einem Substrat (500) und in Berührung mit einer Siliziumschicht (502) oder fakultativ einer Siliziumdioxidisolationsschicht (504) vorgesehen ist,
der zweite Satz von Elektroden (530) mindestens eine Metallschicht (532) und mindestens eine Metalloxidschicht (534) aufweist, wobei der zweite Satz von Elektroden (530) benachbart zu und in Berührung mit einer ferroelektrischen Schicht (520) vorgesehen ist, und
der zweite Satz von Elektroden (530) in einer Vakuumkammer (400) gebildet wird durch thermisches Verdampfen einer Hochreinheits-Verdampfungsquelle (430) von der Effusionszelle (410) auf die Oberfläche der ferroelektrischen Schicht (520), während ein Arbeitsgas bei jeweils einem ersten und einem zweiten Gasdruck vorgesehen ist.

14. Ferroelektrische Speichervorrichtung nach Anspruch 13, **dadurch gekennzeichnet, dass** drei oder mehr Sätze von Elektroden (510, 530, 602, ...) und mindestens zwei ferroelektrische Schichten (520, 600, ...) vorgesehen sind, wobei jeder Satz von Elektroden (510, 630, 602, ...) benachbart zu und in Berührung mit mindestens einer ferroelektrischen Schicht (520, 600, ...) vorgesehen ist und jede ferroelektrische Schicht (520, 600, ...) zwischen und in Berührung mit zwei Sätzen von Elektroden (510, 530; 530, 602, ...) vorgesehen ist.

## Revendications

1. Procédé de fabrication d'une cellule mémoire ferroélectrique comprenant des étapes consistant à :
(a) mettre à disposition un substrat qui consiste en une couche de silicium, et éventuellement une couche d'isolation en dioxyde de silicium ;
(b) former une première électrode comprenant au moins une couche métallique et au moins une couche d'oxyde métallique, et mettre à disposition ladite première électrode de façon adjacente audit substrat et en contact avec ladite couche de silicium ou ladite couche d'isolation en dioxyde de silicium éventuelle ;
(c) former une première couche ferroélectrique qui consiste en un film mince ferroélectrique polymère, et mettre à disposition ladite première couche ferroélectrique de façon adjacente à, et en contact avec, ladite première électrode ;
(d) former une deuxième électrode comprenant au moins une couche métallique et au moins une couche d'oxyde métallique, et mettre à disposition ladite deuxième électrode de façon adjacente à, et en contact avec ladite première couche ferroélectrique, le procédé étant **caractérisé en ce que** l'étape (d) comprend en outre des étapes consistant à :
former une parmi ladite au moins une couche d'oxyde métallique en plaçant ledit substrat, ladite première électrode et ladite première couche ferroélectrique dans une chambre à vide, mettre à disposition une source d'évaporation à haut degré de pureté dans une cellule d'effusion, ladite cellule d'effusion étant prévue dans ladite chambre à vide, évaporer thermiquement ladite source d'évaporation à haut degré d'effusion à partir de ladite cellule d'effusion sur la surface de ladite première couche ferroélectrique pendant que l'on délivre un gaz de travail à une première pression gazeuse ; et former une parmi ladite au moins une couche métallique en faisant s'évaporer thermiquement ladite source d'évaporation à haut degré de pureté à partir de ladite cellule d'effusion sur la surface de ladite au moins une couche d'oxyde métallique pendant que l'on maintient une seconde pression gazeuse.

2. Procédé selon la revendication 1, **caractérisé en ce que** ladite source d'évaporation à haut degré de pureté est du titane à haut degré de pureté.

3. Procédé selon la revendication 2, **caractérisé en ce que** ladite au moins une couche métallique de ladite deuxième électrode est une couche de titane et ladite au moins une couche d'oxyde métallique de ladite deuxième électrode est une couche d'oxyde de titane, de dioxyde de titane ou une combinaison d'oxyde de titane et de dioxyde de titane.

4. Procédé selon la revendication 3, **caractérisé en ce que** ledit gaz de travail est du gaz oxygène.

5. Procédé selon la revendication 1, **caractérisé en ce que** ledit gaz de travail est un mélange gazeux d'au moins du gaz oxygène et du gaz azote.

6. Procédé selon la revendication 5, **caractérisé en ce que** le gaz oxygène représente moins de 50 % en volume dudit gaz de travail et le gaz azote représente plus de 50 % en volume dudit gaz de travail.

7. Procédé selon la revendication 6, **caractérisé en ce que** le gaz oxygène représente de 15 à 25 % en volume dudit gaz de travail.

8. Procédé selon la revendication 1, **caractérisé en ce que** ladite première pression gazeuse dans ladite chambre à vide est comprise entre 133,3.10⁻³ et 133, 3.10⁻⁶ Pa.

9. Procédé selon la revendication 2, **caractérisé en ce que** ladite cellule d'effusion comprend un creuset fabriqué à partir de carbone dans sa forme graphitique.

10. Procédé selon la revendication 9, **caractérisé en ce que** ledit creuset est chauffé jusqu'à une température comprise entre 1 600 et 1 900 degrés centigrade au cours de l'évaporation thermique de ladite source d'évaporation à haut degré de pureté.

11. Procédé selon la revendication 1, **caractérisé en ce qu'**il comprend en outre les étapes consistant à :
(e) former une deuxième couche ferroélectrique qui consiste en un film mince ferroélectrique polymère, ladite deuxième couche ferroélectrique étant mise à disposition de façon adjacente à, et en contact avec, ladite seconde électrode ;
(f) former une troisième électrode comprenant au moins une couche métallique et au moins une couche d'oxyde métallique par évaporation thermique, ladite troisième électrode étant mise à disposition de façon adjacente à, et en contact avec, ladite seconde couche ferroélectrique ;
(g) former une première couche intermédiaire diélectrique qui consiste en un matériau diélectrique, ladite première couche intermédiaire diélectrique étant mise à disposition de façon adjacente à, et en contact avec ladite troisième électrode ; et
(h) répéter les étapes (b) à (g) au moins une fois de sorte qu'une structure empilée d'au moins quatre cellules mémoire ferroélectriques soient fabriquées moyennant quoi le substrat à l'étape (b) est remplacé par l'électrode à l'étape (d) et les électrodes, les couches ferroélectriques et les couches diélectriques sont numérotées de manière correspondante.

12. Procédé selon la revendication 11, **caractérisé en ce que** l'étape (h) est répétée deux fois, et comprenant en outre une étape consistant à :
(i) former une treizième électrode comprenant au moins une couche métallique et au moins une couche d'oxyde métallique, ladite treizième électrode étant connectée électriquement à au moins deux des autres électrodes.

13. Dispositif de mémoire ferroélectrique comprenant des cellules mémoire ferroélectriques capables de stocker des données dans l'un ou l'autre d'au moins deux états de polarisation lorsqu'aucun champ électrique n'est appliqué sur les cellules mémoire, où le dispositif de mémoire ferroélectrique comprend au moins une couche ferroélectrique (520) formée par un film mince ferroélectrique polymère et au moins un premier ensemble et un second ensemble d'électrodes (510, 530) parallèles respectives, où les électrodes (510) du premier ensemble sont prévues dans une relation sensiblement orthogonale par rapport aux électrodes (530) dudit second ensemble, ledit premier ensemble et ledit second ensemble d'électrodes (510, 530) venant en contact avec les cellules mémoire ferroélectriques au niveau des surfaces opposées de ladite au moins une couche ferroélectrique polymère (520), et où au moins le premier ensemble et second ensemble d'électrodes (510, 530) sont adaptés pour lire, rafraîchir, ou écrire des cellules mémoire ferroélectriques par application de tensions appropriées sur celles-ci,
**caractérisé en ce que**
ledit premier ensemble d'électrode (510) comprend au moins une couche métallique (512), et au moins une couche d'oxyde métallique (514), ledit premier ensemble d'électrodes (510) étant mis à disposition de façon adjacente par rapport à un substrat (500) et en contact avec une couche de silicium (502), ou éventuellement, une couche d'isolation en dioxyde de silicium (504), **en ce que** ledit second ensemble d'électrodes (530) comprend au moins une couche métallique (532) et au moins une couche d'oxyde métallique (534), ledit second ensemble d'électrodes (530) étant mis à disposition de façon adjacente à, et en contact avec, une couche ferroélectrique (520), et
**en ce que** ledit second ensemble d'électrodes (530) est formé dans une chambre à vide (400) en faisant s'évaporer thermiquement une source d'évaporation à haut degré de pureté (430) à partir d'une cellule d'effusion (410) sur la surface de ladite couche ferroélectrique (520) pendant que l'on met à disposition un gaz de travail respectivement à une première et une seconde pression gazeuse.

14. Dispositif de mémoire ferroélectrique selon la revendication 13, **caractérisé en ce qu'**il comprend trois ou plusieurs ensembles d'électrodes (510, 530, 602, ...) et au moins deux couches ferroélectriques (520, 600, ...), chaque ensemble d'électrodes (510, 530, 602, ...) étant mis à disposition de façon adjacente à, et en contact avec, au moins une couche ferroélectrique (520, 600) et chaque couche ferroélectrique (520, 600, ...) étant mise à disposition entre, et en contact avec, deux ensembles d'électrodes (510, 530 ; 530, 602 ; ...).
